(19) Europäisches Patentamt
European Patent Office
Office européen des brevets

(11) **EP 4 692 821 A1**

(12) **EUROPEAN PATENT APPLICATION**
published in accordance with Art. 153(4) EPC

(43) Date of publication:
**11.02.2026 Bulletin 2026/07**

(21) Application number: **24868616.4**

(22) Date of filing: **13.09.2024**

(51) International Patent Classification (IPC):
**G01R 31/382** (2019.01)     **G01R 31/385** (2019.01)
**G01R 31/396** (2019.01)     **G01R 31/389** (2019.01)
**G01R 27/08** (2006.01)      **H01M 4/13** (2010.01)
**H01M 10/04** (2006.01)      **H01M 4/02** (2006.01)

(52) Cooperative Patent Classification (CPC):
**G01R 27/08; G01R 31/382; G01R 31/385;
G01R 31/389; G01R 31/396; H01M 4/02;
H01M 4/13; H01M 10/04;** Y02E 60/10

(86) International application number:
**PCT/KR2024/013974**

(87) International publication number:
**WO 2025/063639 (27.03.2025 Gazette 2025/13)**

(84) Designated Contracting States:
**AL AT BE BG CH CY CZ DE DK EE ES FI FR GB
GR HR HU IE IS IT LI LT LU LV MC ME MK MT NL
NO PL PT RO RS SE SI SK SM TR**
Designated Extension States:
**BA**
Designated Validation States:
**GE KH MA MD TN**

(30) Priority: **21.09.2023 KR 20230126639**

(71) Applicant: **LG Energy Solution, Ltd.
Seoul 07335 (KR)**

(72) Inventors:
• **KIM, Dong-Hyun**
  **Daejeon 34122 (KR)**
• **YOON, Seo-Young**
  **Daejeon 34122 (KR)**
• **CHOI, Soon-Hyung**
  **Daejeon 34122 (KR)**

(74) Representative: **Goddar, Heinz J.
Boehmert & Boehmert
Anwaltspartnerschaft mbB
Pettenkoferstrasse 22
80336 München (DE)**

(54) **APPARATUS AND METHOD FOR DIAGNOSING BATTERY**

(57)     A battery diagnosis apparatus according to an embodiment of the present disclosure includes a profile determination unit configured to determine a positive electrode profile of a battery by adjusting a reference positive electrode profile and a reference negative electrode profile to fit into a measured full-cell profile indicating a correspondence relationship between capacity and voltage of the battery; a loading amount calculation unit configured to calculate a positive electrode loading amount of the battery based on the positive electrode profile of the battery; and a condition diagnosis unit configured to compare a resistance of the battery with a preset resistance range and the positive electrode loading amount of the battery with a preset loading amount range, and diagnose a condition of the battery based on the resistance comparison result and the positive electrode loading amount comparison result.

FIG. 1

100

Battery diagnosis apparatus

| Profile determination unit | 110 |
| Loading amount calculation unit | 120 |
| Condition diagnosis unit | 130 |
| Resistance calculation unit | 140 |
| Storage unit | 150 |

**Description**

TECHNICAL FIELD

The present disclosure relates to a battery diagnosis apparatus and method, and more particularly, to a battery diagnosis apparatus and method for diagnosing whether at least one of an active material, a conductive material or a binder is included in a positive electrode of a battery in a larger, smaller or optimal amount.

This application claims priority to Korean Patent Application No. 10-2023-0126639 filed on September 21, 2023 in the Republic of Korea, the disclosure of which is incorporated herein by reference.

BACKGROUND

Recently, there has been a rapid increase in the demand for portable electronic products such as laptop computers, video cameras and mobile phones, and with the extensive development of electric vehicles, accumulators for energy storage, robots and satellites, many studies are being made on high performance batteries that may be repeatedly charged and discharged.

Currently, commercially available batteries include nickel-cadmium batteries, nickel-hydrogen batteries, nickel-zinc batteries, lithium batteries and the like, and among them, lithium batteries have little or no memory effect, and thus they are gaining more attention than nickel-based batteries for their advantages that recharging may be done whenever it is convenient, the self-discharge rate is very low and the energy density is high.

An electrode of a battery is manufactured by coating a slurry containing a mixture of an active material, a conductive material, and a binder on a current collector plate. The active material is a material that produces electrical energy by chemical reaction. For example, in lithium batteries, the positive electrode active material provides lithium ions to the negative electrode during charging, and the negative electrode active material stores and releases the lithium ions during discharging. Therefore, the active material affects the capacity and output of the battery. The conductive material is a material that improves the conduction of electrons between active material particles or between the active material and the metal current collector. The binder is a material that maintains the bonding between the active material and the conductive material, thereby mechanically stabilizing the electrode.

Therefore, the composition ratio of the active material, the conductive material, and the binder is an important factor that determines the performance of the battery.

However, for a procedural reason, the composition ratio of the active material, the conductive material, and the binder may differ from the design ratio. When the composition ratio of the active material, the conductive material, and the binder differs from the design ratio, the performance of the battery may also differ from the design performance. That is, to provide the battery with constant performance, it is necessary to diagnose whether the composition ratio of the active material, the conductive material, and the binder of the manufactured battery is consistent with the design ratio.

However, after the battery is manufactured, in reality, it is impossible to accurately measure the composition ratio of the active material, the conductive material, and the binder without disassembling the battery to directly analyze the electrode. Therefore, there is a need for diagnostic technology for diagnosing whether the composition ratio of the active material, the conductive material, and the binder of the manufactured battery is consistent with the design ratio in a non-destructive manner without needing to disassemble the battery. In other words, there is a need for diagnostic technology for diagnosing whether at least one of the active material, the conductive material or the binder is included in the positive electrode in a larger, smaller or optimal amount.

DISCLOSURE

Technical Problem

The present disclosure is designed to solve the above-described problem, and therefore the present disclosure is directed to providing a battery diagnosis apparatus and method for diagnosing whether at least one of an active material, a conductive material or a binder is included in a positive electrode of a battery in a larger, smaller or optimal amount more conveniently and accurately in a nondestructive manner.

These and other objectives and advantages of the present disclosure may be understood from the following description and will become apparent from the exemplary embodiments of the present disclosure. Also, it will be easily understood that the objectives and advantages of the present disclosure may be realized by the means set forth in the appended claims and a combination thereof.

Technical Solution

A battery diagnosis apparatus according to an aspect of the present disclosure may include a profile determination unit configured to determine a positive electrode profile of a battery by adjusting a reference positive electrode profile and a reference negative electrode profile to fit into a measured full-cell profile indicating a correspondence relationship between capacity and voltage of the battery; a loading amount calculation unit configured to calculate a positive electrode loading amount of the battery based on the positive electrode profile of the battery; and a condition diagnosis unit configured to compare a resistance of the battery with a preset resistance range and the positive electrode loading amount of the battery with a preset loading amount range, and diagnose a condition of the battery based on the resistance comparison result and the positive electrode loading amount comparison result.

The condition diagnosis unit may be configured to diagnose the condition of the battery as normal when the resistance lies within the resistance range and the positive electrode loading amount lies within the loading amount range, and diagnose the condition of the battery as abnormal when the resistance does not lie within the resistance range or the positive electrode loading amount does not lie within the loading amount range.

The abnormal condition may be a condition in which at least one of an active material, a binder, or a conductive material is included in a positive electrode of the battery in a larger amount.

The loading amount calculation unit may be configured to calculate the positive electrode loading amount, taking into account a positive electrode change ratio of the positive electrode profile of the battery with respect to the reference positive electrode profile.

The loading amount calculation unit may be configured to calculate the positive electrode loading amount, taking into account the positive electrode change ratio, a preset reference positive electrode capacity, and a preset reference area.

The loading amount calculation unit may be configured to calculate the positive electrode loading amount indicating a positive electrode capacity per unit area by multiplying the reference positive electrode capacity by the positive electrode change ratio and dividing a product by the reference area.

The resistance range may be a range that is set based on a standard deviation of a resistance distribution of a plurality of reference batteries on the basis of an average of the resistance distribution.

The loading amount range may be a range that is set based on a standard deviation of a positive electrode loading amount distribution of the plurality of reference batteries on the basis of an average of the loading amount distribution.

The battery diagnosis apparatus according to another aspect of the present disclosure may further include a resistance calculation unit configured to calculate the resistance of the battery based on the measured full-cell profile.

A battery manufacturing system according to still another aspect of the present disclosure may include the battery diagnosis apparatus according to an aspect of the present disclosure.

A battery pack according to yet another aspect of the present disclosure may include the battery diagnosis apparatus according to an aspect of the present disclosure.

A battery diagnosis method according to further another aspect of the present disclosure may include a positive electrode profile determination step of determining a positive electrode profile of a battery by adjusting a reference positive electrode profile and a reference negative electrode profile to fit into a measured full-cell profile indicating a correspondence relationship between capacity and voltage of the battery; a positive electrode loading amount calculation step of calculating a positive electrode loading amount of the battery based on the positive electrode profile of the battery; a comparison step of comparing a resistance of the battery with a preset resistance range and the positive electrode loading amount of the battery with a preset loading amount range; and a condition diagnosis step of diagnosing a condition of the battery based on the resistance comparison result and the positive electrode loading amount comparison result of the comparison step.

Advantageous Effects

According to an aspect of the present disclosure, it may be possible to diagnose whether at least one of the active material, the conductive material or the binder is included in the positive electrode of the battery in a larger, smaller or optimal amount more conveniently and accurately in a non-destructive manner.

Furthermore, according to an aspect of the present disclosure, because the resistance and positive electrode loading amount of the battery are used to diagnose the condition of the battery in a complementary way, it may be possible to improve the accuracy of battery condition diagnosis.

In addition, according to an aspect of the present disclosure, it may be possible to diagnose the condition of the positive electrode in a detailed and precise manner based on the resistance comparison result and the positive electrode loading amount comparison result. Moreover, because the condition of the positive electrode is diagnosed in detail, it may be possible to identify the cause of the manufacturing problem of the corresponding battery quickly.

Additionally, according to an aspect of the present disclosure, because the positive electrode capacity per unit area is considered when diagnosing the condition of the battery, it may be possible to consistently diagnose the condition of the battery irrespective of the total amount of the positive electrode.

The effects of the present disclosure are not limited to the aforementioned effects, and these and other effects will be clearly understood by those skilled in the art from the appended claims.

BRIEF DESCRIPTION OF THE DRAWINGS

The accompanying drawings illustrate the exemplary embodiments of the present disclosure and together with the following detailed description, serve to provide a better understanding of the technical aspect of the present disclosure, and thus the present disclosure should not be constructed as being limited to the drawings.

FIG. 1 is a diagram schematically showing a battery diagnosis apparatus according to an embodiment of the present disclosure.

FIGS. 2 and 3 are diagrams referenced in describing the amounts of an active material, a conductive material, and a binder according to the resistance comparison result and the positive electrode loading amount comparison result.

FIG. 4 is a graph referenced in describing an example of each of a reference positive electrode profile and a reference negative electrode profile.

FIG. 5 is a graph referenced in describing an example of a measured full-cell profile of a target cell.

FIGS. 6 to 8 are diagrams referenced in describing an example of a procedure for generating a comparative full-cell profile used for comparison with a measured full-cell profile according to an embodiment of the present disclosure.

FIGS. 9 to 11 are diagrams referenced in describing another example of a procedure for generating a comparative full-cell profile used for comparison with a measured full-cell profile according to an embodiment of the present disclosure.

FIG. 12 is a diagram showing an exemplary configuration of a battery pack including a battery diagnosis apparatus according to an embodiment of the present disclosure.

FIG. 13 is a flowchart exemplarily showing a battery diagnosis method according to an embodiment of the present disclosure.

BEST MODE

It should be understood that the terms or words used in the specification and the appended claims should not be construed as being limited to general and dictionary meanings, and rather, may be interpreted based on the meanings and concepts corresponding to the technical aspect of the present disclosure on the basis of the principle that the inventor is allowed to define the terms appropriately for the best explanation.

Therefore, the embodiments described herein and the illustrations shown in the drawings are exemplary embodiments of the present disclosure to describe the technical aspect of the present disclosure and are not intended to be limiting, so it should be understood that a variety of other equivalents and modifications could have been made thereto at the time the application was filed.

In describing the present disclosure, a detailed description of related known elements or functions that may make the subject matter of the present disclosure obscure or unclear, is omitted.

The terms "first", "second" and the like, are used to distinguish one element from another among various elements, but not intended to limit the elements by the terms.

Unless the context clearly indicates otherwise, the terms "comprise" and "include" when used in this specification, specify the presence of stated elements, but do not preclude the presence or addition of one or more other elements.

In addition, throughout the specification, it will be further understood that when an element is referred to as being "connected to" another element, it may be directly connected to the other element or intervening elements may be present.

Hereafter, the exemplary embodiments of the present disclosure will be described in detail with reference to the accompanying drawings.

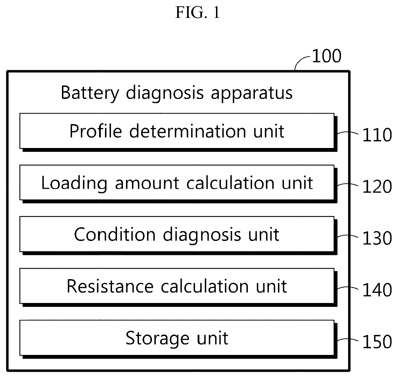

FIG. 1 is a diagram schematically showing a battery diagnosis apparatus 100 according to an embodiment of the present disclosure.

Referring to FIG. 1, the battery diagnosis apparatus 100 according to an embodiment of the present disclosure may include a profile determination unit 110, a loading amount calculation unit 120, and a condition diagnosis unit 130. The battery diagnosis apparatus 100 may further include a resistance calculation unit 140. The battery diagnosis apparatus 100 may further include a storage unit 150.

Here, a battery refers to a physically separable and independent cell having a negative terminal and a positive terminal. For example, a lithium ion battery or a lithium polymer battery may be deemed as the battery.

The profile determination unit 110 may be configured to determine a positive electrode profile of the battery by adjusting a reference positive electrode profile and a reference negative electrode profile to fit into a measured full-cell profile indicating a correspondence relationship between capacity and voltage of the battery.

Here, the measured full-cell profile is a profile generated based on capacity and voltage measured during charging or discharging of the battery. For example, the measured full-cell profile may be a profile indicating the correspondence relationship between capacity and voltage measured during charging of the battery. In other words, the measured full-cell profile may be a capacity (Q)-voltage (V) profile of the battery.

The reference positive electrode profile may be a profile indicating the correspondence relationship between capacity and voltage of a preset reference positive cell for the positive electrode of the battery. For example, the reference positive cell may be a positive coin half-cell or a positive electrode of a triple-electrode cell. Additionally, the reference negative electrode profile may be a profile indicating the correspondence relationship between capacity and voltage of a preset reference negative cell for the negative electrode of the battery. For example, the reference negative cell may be a negative coin half-cell or a negative electrode of a triple-electrode cell.

Specifically, the profile determination unit 110 may adjust the reference positive electrode profile and the reference negative electrode profile to fit into the measured full-cell profile. More specifically, the profile determination unit 110 may adjust the reference positive electrode profile and the reference negative electrode profile to generate an adjusted positive electrode profile and an adjusted negative electrode profile. In addition, the profile determination unit 110 may generate a comparative full-cell profile from the adjusted positive electrode profile and the adjusted negative electrode profile. The profile determination unit 110 may adjust the reference positive electrode profile and the reference negative electrode profile until the comparative full-cell profile matches the measured full-cell profile.

For example, the profile determination unit 110 may shift or capacity-scale the reference positive electrode profile and the reference negative electrode profile to generate a plurality of comparative full-cell profiles, and select any one comparative full-cell profile having the minimum error with the measured full-cell profile among the plurality of comparative full-cell profiles.

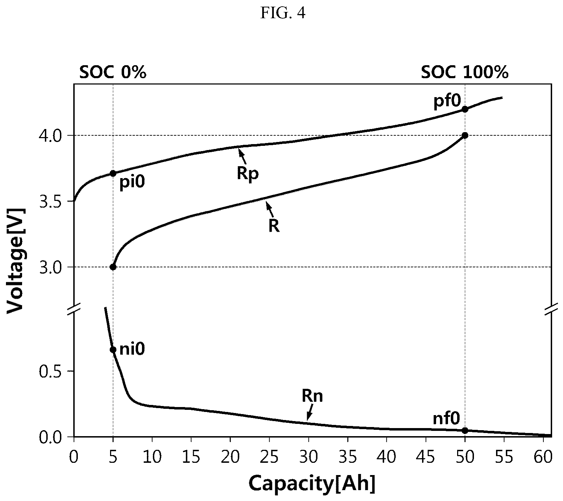

In relation to this, the embodiment in which the profile determination unit 110 determines the positive electrode profile of the battery by adjusting the reference positive electrode profile and the reference negative electrode profile to fit into the measured full-cell profile will be described in more detail below with reference to FIGS. 4 to 8.

The loading amount calculation unit 120 may be configured to calculate a positive electrode loading amount of the battery based on the positive electrode profile of the battery.

Here, the positive electrode loading amount of the battery may refer to an amount of positive electrode active material coated on the positive current collector. The positive electrode profile of the battery may be a profile that is generated from the reference positive electrode profile and indicates the current condition of the positive electrode of the battery. Therefore, the loading amount calculation unit 120 may calculate the positive electrode loading amount of the battery based on the positive electrode profile. The embodiment in which the loading amount calculation unit 120 calculates the positive electrode loading amount from the positive electrode profile will be described below.

The condition diagnosis unit 130 may be configured to compare the resistance of the battery with a preset resistance range.

Here, the resistance range may be preset based on the resistance distribution of a plurality of reference batteries for the target battery. Preferably, the reference battery may have the same type and specification as the battery (hereinafter referred to as 'target battery') to be diagnosed by the battery diagnosis apparatus 100.

For example, the resistance range may be a range that is set based on the average and standard deviation of resistance distribution of the plurality of reference batteries. Specifically, the resistance range may be set to a range of 3 standard deviations from the average of resistance distribution of the plurality of reference batteries. That is, the lower limit of the resistance range may be set to a value obtained by subtracting 3 standard deviations from the average, and the upper limit of the resistance range may be set to a value obtained by adding 3 standard deviations to the average.

The condition diagnosis unit 130 may determine whether the resistance of the battery lies within the preset resistance range by comparing the resistance of the battery with the preset resistance range. For example, when the resistance of the battery is equal to or less than the upper limit of the resistance range and equal to or more than the lower limit, the condition diagnosis unit 130 may determine that the resistance of the battery lies within the resistance range. On the contrary, when the resistance of the battery is more than the upper limit of the resistance range or less than the lower limit, the condition diagnosis unit 130 may determine that the resistance of the battery does not lie within the resistance range.

The condition diagnosis unit 130 may be configured to compare the positive electrode loading amount of the battery with a preset loading amount range.

Here, the loading amount range may be preset based on the positive electrode loading amount distribution of the plurality of reference batteries corresponding to the target battery.

For example, the loading amount range may be a range that is set based on the average and standard deviation of positive electrode loading amount distribution of the plurality of reference batteries. Specifically, the loading amount range may be set to a range of 3 standard deviations from the average of positive electrode loading amount distribution of the plurality of reference batteries. That is, the lower limit of the loading amount range may be set to a value obtained by subtracting 3 standard deviations from the average, and the upper limit of the loading amount range may be set to a value obtained by adding 3 standard deviations to the average.

The condition diagnosis unit 130 may determine whether the positive electrode loading amount of the battery lies within the preset loading amount range by comparing the positive electrode loading amount of the battery with the preset loading amount range. For example, when the positive electrode loading amount of the battery is equal to or less than the upper limit of the loading amount range and equal to or more than the lower limit, the condition diagnosis unit 130 may determine that the positive electrode loading amount of the battery lies within the loading amount range. On the contrary, when the positive electrode loading amount of the battery is more than the upper limit of the loading amount range or less than the lower limit, the condition diagnosis unit 130 may determine that the positive electrode loading amount of the battery does not lie within the loading amount range.

In an embodiment, the resistance range may be set based on the resistance distribution of the plurality of reference batteries and the target battery. Additionally, the loading amount range may be set based on the positive electrode loading amount distribution of the plurality of reference batteries and the target battery.

The condition diagnosis unit 130 may be configured to diagnose the condition of the battery based on the resistance comparison result and the positive electrode loading amount comparison result.

Specifically, the condition diagnosis unit 130 may be configured to diagnose the condition of the battery as normal when the resistance lies within the resistance range and the positive electrode loading amount lies within the loading amount range. On the contrary, the condition diagnosis unit 130 may be configured to diagnose the condition of the battery as abnormal when the resistance does not lie within the resistance range or the positive electrode loading amount does not lie within the loading amount range.

The battery diagnosis apparatus 100 according to an embodiment of the present disclosure diagnoses the condition of the battery, taking into account both the resistance and the positive electrode loading amount of the battery. That is, according to the battery diagnosis apparatus 100, because the resistance and the positive electrode loading amount of the battery are used to diagnose the condition of the battery in a complementary way, it may be possible to improve the accuracy of battery condition diagnosis.

Meanwhile, the profile determination unit 110, the loading amount calculation unit 120, the condition diagnosis unit 130, and the resistance calculation unit 140 of the battery diagnosis apparatus 100 may selectively include a processor, an application-specific integrated circuit (ASIC), another chipset, a logic circuit, a register, a communication modem or a data processing device known in the technical field to execute many different control logics performed in the present disclosure. In addition, when the control logic is implemented as software, each component of the battery diagnosis apparatus 100 may be implemented as a set of program modules.

Meanwhile, the battery diagnosis apparatus 100 may further include the storage unit 150. The storage unit 150 may store data or programs necessary for each component of the battery diagnosis apparatus 100 to perform operations and functions, or data created in the process of performing the operations and functions. The storage unit 150 is not limited to a particular type and may include any information storage means known as being able to record, erase, update, and read data. As an example, the information storage means may include RAM, flash memory, ROM, EEPROM, or register. In addition, the storage unit 150 may store program codes defining the processes that may be performed by each component of the battery diagnosis apparatus 100.

The condition diagnosis unit 130 may diagnose the condition of the battery as normal or abnormal based on the resistance comparison result and the positive electrode loading amount comparison result. Here, the abnormal condition may be a condition in which at least one of an active material, a conductive material, or a binder is included in the positive electrode of the battery in a larger amount.

The positive electrode of the battery is generally manufactured by coating a slurry containing a mixture of the active material, the conductive material, and the binder on a current collector plate. Therefore, the battery in the abnormal condition may include at least one of the active material, the conductive material, or the binder in the positive electrode in a larger amount.

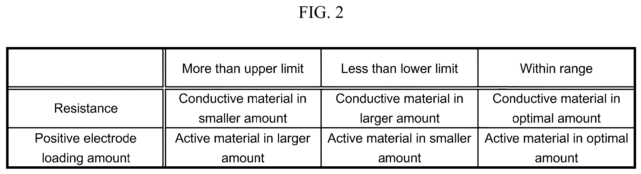

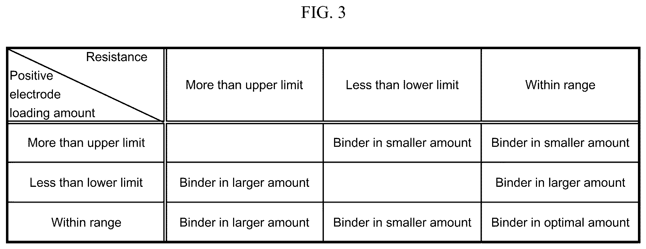

FIGS. 2 and 3 are diagrams referenced in describing the amounts of the active material, the conductive material, and the binder according to the resistance comparison result and the positive electrode loading amount comparison result.

Referring to FIG. 2, the amount of the conductive material may be determined according to the resistance comparison result, and the amount of the active material may be determined according to the positive electrode loading amount comparison result.

Specifically, the condition diagnosis unit 140 may diagnose whether the conductive material is included in a larger, smaller or optimal amount according to the result of comparing the resistance with the resistance range. For example, when the resistance lies within the resistance range, the condition diagnosis unit 140 may diagnose that the conductive material is included in an optimal amount. When the resistance is more than the upper limit of the resistance range, the condition diagnosis unit 140 may diagnose that the conductive material is included in a larger amount. When the resistance is less than the lower limit of the resistance range, the condition diagnosis unit 140 may diagnose that the conductive material is included in a smaller amount.

The conductive material is a material that improves the conduction of electrons between active material particles or between the active material and the metal current collector. In other words, the conductive material is a material that allow a flow of current in the electrode of the battery. Therefore, when the ratio of the conductive material is lower, the resistance of the battery increases, and when the ratio of the conductive material is higher, the resistance of the battery decreases.

Specifically, the condition diagnosis unit 140 may diagnose whether the active material is included in a larger, smaller or optimal according to the result of comparing the positive electrode loading amount with the loading amount range. For example, when the positive electrode loading amount lies within the loading amount range, the condition diagnosis unit 140 may diagnose that the active material is included in an optimal amount. When the positive electrode loading amount is more than the upper limit of the loading amount range, the condition diagnosis unit 140 may diagnose that the active material is included in a larger amount. When the positive electrode loading amount is less than the lower limit of the loading amount range, the condition diagnosis unit 140 may diagnose that the active material is included in a smaller amount.

The active material is a material that produces electrical energy by chemical reaction. For example, in lithium batteries, the positive electrode active material provides lithium ions to the negative electrode during charging, and the negative electrode active material stores and releases the lithium ions during discharging. Therefore, the active material affects the capacity and output of the battery. Specifically, as the amount of the positive electrode active material increases, the capacity of the positive electrode increases. In other words, as the amount of the positive electrode active material increases, the positive electrode loading amount or the capacity of the positive electrode per unit area increases.

Referring to FIG. 3, the amount of the binder may be indirectly determined according to the amount of the active material and the amount of the conductive agent. That is, assuming that the amount of the slurry containing the mixture of the active material, the conductive agent, and the binder is constant, the amount of the binder may be determined according to the amount of the conductive agent and the amount of the active material. For example, the condition diagnosis unit 140 may diagnose whether the binder is included in a larger, smaller or optimal amount.

There may be a total of nine embodiments according to the amount of each of the active material, the conductive agent, and the binder. One is an embodiment in which the active material, the conductive agent, and the binder are all included in an optimal amount. The total of eight embodiments are embodiments in which at least one of the active material, the conductive agent, or the binder is included in a larger amount.

When the resistance is more than the upper limit of the resistance range and the positive electrode loading amount is more than the upper limit of the loading amount range, the condition diagnosis unit 130 may diagnose that the conductive material is included in a smaller amount and the active material is included in a larger amount. In addition, the binder may be included in a larger, smaller or optimal amount. Here, the amount of the binder may be determined based on the amount of the conductive material and the amount of the active material.

When the resistance is more than the upper limit of the resistance range and the positive electrode loading amount is less than the lower limit of the loading amount range, the condition diagnosis unit 130 may diagnose that the conductive material is included in a smaller amount, the active material is included in a smaller amount, and the binder is included in a larger amount.

When the resistance is more than the upper limit of the resistance range and the positive electrode loading amount lies within the loading amount range, the condition diagnosis unit 130 may diagnose that the conductive material is included in a smaller amount, the active material is included in an optimal amount, and the binder is included in a larger amount.

When the resistance is less than the lower limit of the resistance range and the positive electrode loading amount is more than the upper limit of the loading amount range, the condition diagnosis unit 130 may diagnose that the conductive material is included in a larger amount, the active material is included in a larger amount, and the binder is included in a smaller amount.

When the resistance is less than the lower limit of the resistance range and the positive electrode loading amount is less than the lower limit of the loading amount range, the condition diagnosis unit 130 may diagnose that the conductive material is included in a larger amount and the active material is included in a smaller amount. In addition, the binder may be included in a larger, smaller or optimal amount. Here, the amount of the binder may be determined based on the amount of the conductive material and the amount of the active material.

When the resistance is less than the lower limit of the resistance range and the positive electrode loading amount lies within the loading amount range, the condition diagnosis unit 130 may diagnose that the conductive material is included in a larger amount, the active material is included in an optimal amount, and the binder is included in a smaller amount.

When the resistance lies within the resistance range and the positive electrode loading amount is more than the upper limit of the loading amount range, the condition diagnosis unit 130 may diagnose that the conductive material is included in an optimal amount, the active material is included in a larger amount, and the binder is included in a smaller amount.

When the resistance lies within the resistance range and the positive electrode loading amount is less than the lower limit of the loading amount range, the condition diagnosis unit 130 may diagnose that the conductive material is included in an optimal amount, the active material is included in a smaller amount, and the binder is included in a larger amount.

When the resistance lies within the resistance range and the positive electrode loading amount lies within the loading amount range, the condition diagnosis unit 130 may diagnose that the active material, the conductive material, and the binder are included in optimal amounts.

The battery diagnosis apparatus 100 according to an embodiment of the present disclosure may diagnose the condition of the positive electrode in a detailed and precise manner based on the resistance comparison result and the positive electrode loading amount comparison result. In addition, because the condition of the positive electrode is diagnosed in detail, it may be possible to identify the cause of the manufacturing problem of the battery quickly.

Hereinafter, the embodiment in which the loading amount calculation unit 120 calculates the positive electrode loading amount from the positive electrode profile will be described in detail.

The loading amount calculation unit 120 may be configured to calculate the positive electrode loading amount, taking into account a positive electrode change ratio of the positive electrode profile of the battery with respect to the reference positive electrode profile.

Here, the positive electrode change ratio may refer to a change ratio [%] of the positive electrode profile of the battery to the reference positive electrode profile. Specifically, the positive electrode change ratio may be a contraction or expansion ratio of the positive electrode profile of the battery with respect to the reference positive electrode profile.

For example, when the positive electrode profile of the battery is generated by 10% contraction of the reference positive electrode profile, the positive electrode change ratio is 90%. When the positive electrode profile of the battery is generated by 10% expansion of the reference positive electrode profile, the positive electrode change ratio is 110%.

That is, when the positive electrode change ratio is smaller than 100%, the positive electrode profile of the battery is generated by contraction adjustment of the reference positive electrode profile. When the positive electrode change ratio is larger than 100%, the positive electrode profile of the battery is generated by expansion adjustment of the reference positive electrode profile. Additionally, when the positive electrode change ratio is 100%, the positive electrode profile of the battery is generated without contraction or expansion adjustment of the reference positive electrode profile.

Specifically, the loading amount calculation unit 120 may be configured to calculate the positive electrode loading amount, taking into account the positive electrode change ratio, a preset reference positive electrode capacity, and a preset reference area.

Here, the reference positive electrode capacity may refer to a preset capacity of the reference positive cell. The reference area may refer to a preset area of the reference positive cell.

Specifically, the loading amount calculation unit 120 may be configured to calculate the positive electrode capacity per unit area as the positive electrode loading amount by multiplying the reference positive electrode capacity by the positive electrode change ratio and dividing the product by the reference area.

Because the positive electrode change ratio is the change ratio of the positive electrode profile of the battery to the reference positive electrode profile, the positive electrode capacity of the battery may be calculated by multiplying the reference positive electrode capacity by the positive electrode change ratio. When the calculated positive electrode capacity of the battery is divided by the reference area, the positive electrode loading amount indicating the positive electrode capacity per unit area in the battery may be calculated.

To put it another way, when the reference positive electrode capacity is divided by the reference area, the reference positive electrode capacity per unit area may be calculated. When the reference positive electrode capacity per unit area is multiplied by the positive electrode change ratio, the positive electrode capacity per unit area in the battery may be calculated.

Specifically, the loading amount calculation unit 120 may calculate the positive electrode loading amount based on the positive electrode change ratio, the reference positive electrode capacity, and the reference area by using the following Equation 1.

[Equation 1]

$$P - \text{loading} = ps \times Q_r \div A_{pc}$$

Here, P-loading denotes the positive electrode loading, and ps denotes the positive electrode change ratio. $Q_r$ denotes the reference positive electrode capacity, and $A_{pc}$ denotes the reference area.

For example, when the area of the battery is equal to the reference area, the area of the battery may be replaced with the reference area.

[Equation 2]

$$\text{P} - \text{loading} = \text{ps} \times Q_r \div A_{fc}, \quad A_{fc} = A_{pc}$$

Here, $A_{fc}$ denotes the area of the battery. In Equation 2, $A_{fc}$ may be replaced with $A_{pc}$, so Equation 1 may be derived from Equation 2. For example, the positive electrode loading amount calculated by multiplying the reference positive electrode capacity by the positive electrode change ratio and dividing the product by the area of the battery may be equal to the positive electrode loading amount calculated according to Equation 1.

As another example, when the area of the battery is different from the reference area, it is necessary to scale the area. That is, it is necessary to multiply the reference positive electrode capacity by the positive electrode change ratio, divide the product by the area of the battery, and multiply the result by an area ratio. Here, the area ratio may refer to a ratio of the area of the battery to the area of the reference positive cell. For example, the area ratio may be calculated as a ratio of the area of the battery to the reference area.

For example, when the area of the battery is different from the reference area, the loading amount calculation unit 120 may calculate the positive electrode loading amount using the following Equation 3.

[Equation 3]

$$\text{P} - \text{loading} = \text{ps} \times Q_r \div A_{fc} \times \left( A_{fc} \div A_{pc} \right)$$

In Equation 3, when $A_{fc}$ is eliminated, the result may be Equation 1. That is, when the area of the battery is equal to the reference area and when the area of the battery is not equal to the reference area, the positive electrode capacity (P-loading) per unit area may be calculated according to Equation 1.

Because the battery diagnosis apparatus 100 considers the positive electrode capacity per unit area when diagnosing the condition of the battery, it may be possible to consistently diagnose the condition of the battery irrespective of the total amount of the positive electrode.

The battery diagnosis apparatus 100 according to an embodiment of the present disclosure may further include the resistance calculation unit 140 configured to calculate the resistance of the battery based on the measured full-cell profile (M).

Specifically, the resistance calculation unit 140 may be configured to calculate the resistance of the battery by calculating a voltage difference between a first voltage at a first time and a second voltage at a second time and a ratio of current amount from the first time to the second time. Here, the first time and the second time are different times.

For example, when the second time is 10 seconds later than the first time, the resistance calculated by the resistance calculation unit 140 may be 10-second resistance (R10) of the battery. That is, the resistance calculation unit 140 may calculate the resistance of the battery based on a voltage change for a predetermined period of time (for example, 10 seconds).

In general, the resistance of the battery may be calculated through Ohm's law, which states a ratio of voltage to current. Accordingly, the resistance calculation unit 140 may calculate the resistance of the battery by calculating the equation "(second voltage - first voltage) ÷ current amount".

Below is a detailed description of the embodiment in which the profile determination unit 110 determines the positive electrode profile of the battery by adjusting the reference positive electrode profile and the reference negative electrode profile to fit into the measured full-cell profile.

FIG. 4 is a graph referenced in describing an example of each of the reference positive electrode profile (Rp) and the reference negative electrode profile (Rn). In the graph of FIG. 4, the horizontal axis (X-axis) indicates capacity (Ah) and the vertical axis (Y-axis) indicates voltage (V).

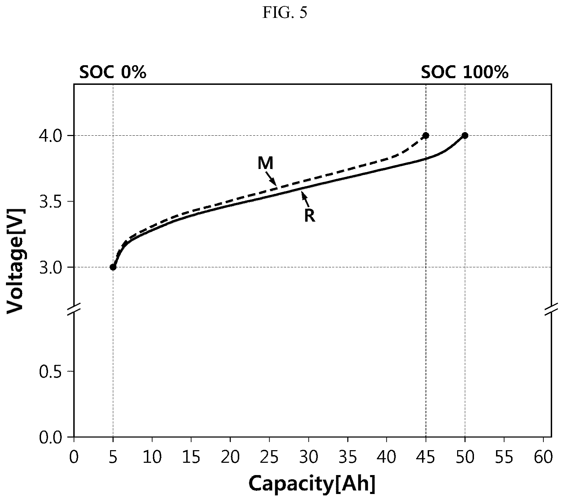

FIG. 5 is a graph referenced in describing an example of the measured full-cell profile (M) of the target cell. In the graph of FIG. 5, the horizontal axis (X-axis) indicates capacity (Ah) and the vertical axis (Y-axis) indicates voltage (V).

The profile determination unit 110 may be configured to compare the measured full-cell profile (M) with at least one comparative full-cell profile. Here, the comparative full-cell profile may be a result of adjusting each of the reference positive electrode profile (Rp) and the reference negative electrode profile (Rn) stored in the storage unit 150 to generate an adjusted positive electrode profile and an adjusted negative electrode profile, and synthesizing (combining) the adjusted positive electrode profile and the adjusted negative electrode profile.

That is, when the reference full-cell profile (R) is a result of subtracting a part of the reference negative electrode profile (Rn) from a part of the reference positive electrode profile (Rp), the comparative full-cell profile may be a result of subtracting a part of the adjusted negative electrode profile from a part of the adjusted positive electrode profile.

The profile determination unit 110 may generate at least one comparative full-cell profile by directly adjusting the reference positive electrode profile (Rp) and the reference negative electrode profile (Rn). Alternatively, the at least one comparative full-cell profile may be pre-stored in the storage unit 150 based on the reference positive electrode profile (Rp) and the reference negative electrode profile (Rn). In this case, the profile determination unit 110 may be obtained by accessing the storage unit 150 to retrieve the comparative full-cell profile.

The profile determination unit 110 may generate the plurality of comparative full-cell profiles from the reference positive electrode profile (Rp) and the reference negative electrode profile (Rn) by repeating the adjustment procedure of adjusting each of the reference positive electrode profile (Rp) and the reference negative electrode profile (Rn) to multiple levels and synthesizing them. The comparative full-cell profile may be referred to as 'adjusted reference full-cell profile'.

The profile determination unit 110 may select any one comparative full-cell profile having the minimum error with the measured full-cell profile (M) among the plurality of comparative full-cell profiles.

Subsequently, the profile determination unit 110 may determine the adjusted positive electrode profile and the adjusted negative electrode profile mapped to the selected comparative full-cell profile as a positive electrode profile and a negative electrode profile of the battery.

In relation to this, a variety of known methods at the time the present application was filed may be used to determine the error between two profiles, each represented in a two-dimensional coordinate system. For example, the integral of absolute value of the area between the two profiles or the Root Mean Square Error (RMSE) may be used as the error between the two profiles.

According to this configuration of the present disclosure, various condition information of the battery may be obtained based on the finally determined positive electrode profile and negative electrode profile. The finally determined positive electrode profile and negative electrode profile may be ones mapped to the comparative full-cell profile having the minimum error. In particular, the comparative full-cell profile by the finally determined positive electrode profile and negative electrode profile may almost match the measured full-cell profile (M).

Therefore, according to the present disclosure, the positive electrode profile and the negative electrode profile of the battery may be obtained in a non-destructive manner.

In the case of a new battery, analysis of the positive electrode profile and the negative electrode profile of the battery may be used to diagnose if any defect occurred in the battery and if so, the type of the defect more easily.

When the battery verified as good is in use, the level of degradation of the battery may be determined for each degradation item, through the positive electrode profile and the negative electrode profile of the battery.

Moreover, according to an embodiment of the present disclosure, the positive electrode profile and the negative electrode profile of the battery may be obtained in a straightforward manner. The present disclosure may be realized even when only one reference positive electrode profile (Rp) and only one reference negative electrode profile (Rn) are stored in the storage unit 150. That is, it is not necessary to store a plurality of reference positive electrode profiles (Rp) and/or a plurality of reference negative electrode profiles (Rn) in the storage unit 150. Accordingly, there is no need for high storage capacity of the storage unit 150, and a large number of pre-tests required for a plurality of reference positive electrode profiles (Rp) and/or a plurality of reference negative electrode profiles (Rn).

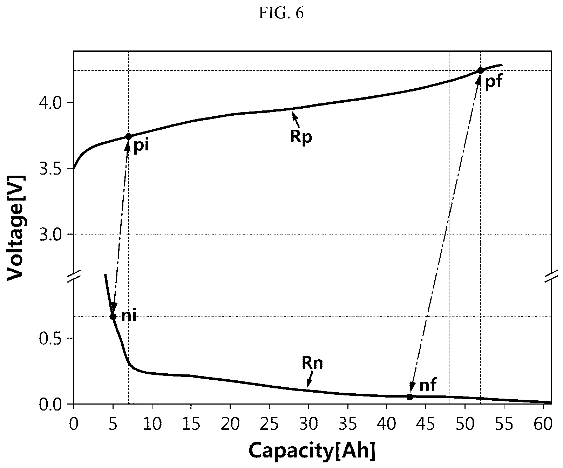

FIGS. 6 to 8 are diagrams referenced in describing an example of the procedure for generating the comparative full-cell profile used for comparison with the measured full-cell profile (M) according to an embodiment of the present disclosure.

The procedure for generating the comparative full-cell profile as described with reference to FIGS. 6 to 8 is performed in an order of a first routine (see FIG. 4) of setting four points (a positive electrode participation start point, a positive electrode participation end point, a negative electrode participation start point, and a negative electrode participation end point) corresponding to a voltage range of interest, a second routine (see FIG. 5) of performing profile shift, and a third routine (see FIG. 6) of performing capacity scaling. That is, the procedure for generating the comparative full-cell profile according to an embodiment of the present disclosure includes the first to third routines.

First, referring to FIG. 6, the reference positive electrode profile (Rp) and the reference negative electrode profile (Rn) are the same as those shown in FIG. 4.

The profile determination unit 110 determines the positive electrode participation start point (pi), the positive electrode participation end point (pf), the negative electrode participation start point (ni), and the negative electrode participation end point (nf) on the reference positive electrode profile (Rp) and the reference negative electrode profile (Rn).

Any one of the positive electrode participation start point (pi) and the negative electrode participation start point (ni) relies on the other.

As an example, the profile determination unit 110 may divide the positive electrode voltage range from the start point to the end point (or the second set voltage) of the reference positive electrode profile (Rp) into a plurality of voltage subranges, and set the boundary point of two adjacent voltage subranges among the plurality of voltage subranges as the positive electrode participation start point (pi). Each voltage subrange may have a predetermined size (for example, 0.01 V). Subsequently, the profile determination unit 110 may set a point on the reference negative electrode profile (Rn) that is smaller than the positive electrode participation start point (pi) by the first set voltage (for example, 3 V) as the negative electrode participation start point (ni).

As another example, the profile determination unit 110 may divide the negative electrode voltage range from the start point to the end point of the reference negative electrode profile (Rn) into a plurality of voltage subranges of a predetermined size, and set the boundary point of two adjacent voltage subranges among the plurality of voltage subranges as the negative electrode participation start point (ni). Subsequently, the profile determination unit 110 may search for a point that is larger than the negative electrode participation start point (ni) by the first set voltage from the reference positive electrode profile (Rp), and set the found point as the positive electrode participation start point (pi).

Any one of the positive electrode participation end point (pf) and the negative electrode participation end point (nf) relies on the other.

As an example, the profile determination unit 110 may divide the voltage range from the second set voltage to the end point of the reference positive electrode profile (Rp) into a plurality of voltage subranges of a predetermined size, and set the boundary point of two adjacent voltage subranges among the plurality of voltage subranges as the positive electrode participation end point (pf). Subsequently, the profile determination unit 110 may set a point on the reference negative electrode profile (Rn) that is smaller than the positive electrode participation end point (pf) by the second set voltage (for example, 4 V) as the negative electrode participation end point (nf).

As another example, the profile determination unit 110 may divide the negative electrode voltage range from the start point to the end point of the reference negative electrode profile (Rn) into a plurality of voltage subranges of a predetermined size, and set the boundary point of two adjacent voltage subranges among the plurality of voltage subranges as the negative electrode participation end point (nf). Subsequently, the profile determination unit 110 may search for a point that is larger than the negative electrode participation end point (nf) by the second set voltage from the reference positive electrode profile (Rp), and set the found point as the positive electrode participation end point (pf).

When the determination of the positive electrode participation start point (pi), the positive electrode participation end point (pf), the negative electrode participation start point (ni), and the negative electrode participation end point (nf) is completed, the profile determination unit 110 shifts at least one of the reference positive electrode profile (Rp) and the reference negative electrode profile (Rn) to the left or right along the horizontal axis.

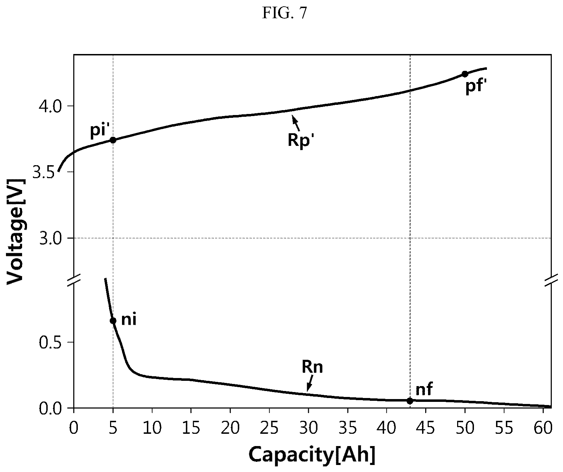

Referring to FIG. 7, the profile determination unit 110 may shift the reference positive electrode profile (Rp) to the left (lower capacity), or shift the reference negative electrode profile (Rn) to the right (higher capacity) singly or in combination, to match the capacity values of the positive electrode participation start point (pi) and the negative electrode participation start point (ni).

Alternatively, the profile determination unit 110 may shift the reference positive electrode profile (Rp) to the left, or shift the reference negative electrode profile (Rn) to the right singly or in combination, to match the capacitance values of the positive electrode participation end point (pf) and the negative electrode participation end point (nf).

FIG. 7 illustrates a situation in which the capacity value of the positive electrode participation start point (pi') matches the capacity value of the negative electrode participation start point (ni) as a result of shifting only the reference positive electrode profile (Rp) to the left to generate an adjusted reference positive electrode profile (Rp'). The adjusted reference positive electrode profile (Rp') is the result of applying the adjustment procedure for shifting to the left by a capacity difference between the positive electrode participation start point (pi) and the negative electrode participation start point (ni) to the reference positive electrode profile (Rp). Therefore, the two points (pi, pi') are the same in voltage, and only different in capacity value. The two points (pf, pf) are the same in voltage, and only different in capacity value.

When the adjusted profiles (Rp', Rn) are generated by shifting at least one of the reference positive electrode profile (Rp) and the reference negative electrode profile (Rn), the profile determination unit 110 scales the capacity range of at least one of the adjusted profiles (Rp', Rn).

According to the example shown in FIG. 7, the profile determination unit 110 performs an additional adjustment procedure to contract or expand at least one of the adjusted reference positive electrode profile (Rp') or the reference negative electrode profile (Rn) along the horizontal axis.

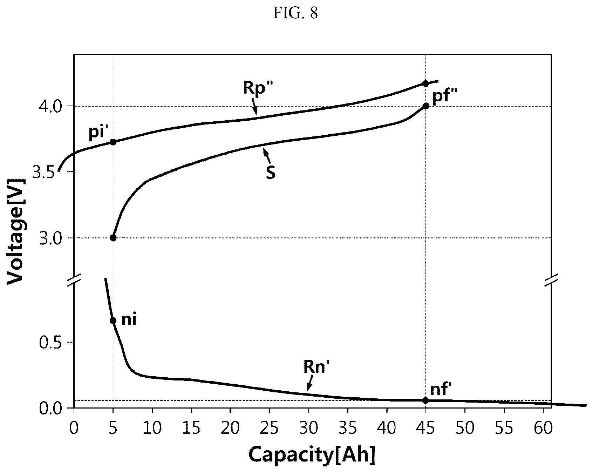

Referring to FIG. 8, the profile determination unit 110 may contract or expand the adjusted reference positive electrode profile (Rp') to generate an adjusted reference positive electrode profile (Rp"), in order to match the capacity range between the two points (pi', pf') of the adjusted reference positive electrode profile (Rp') with the capacity range of the measured full-cell profile (M). In this instance, any one of the two points (pi', pf) may be fixed. Accordingly, the capacity range between the two points (pi', pf') of the adjusted reference positive electrode profile (Rp") may match the capacity range of the measured full-cell profile (M).

In addition, the profile determination unit 110 may contract or expand the reference negative electrode profile (Rn) to generate an adjusted reference negative electrode profile (Rn'), in order to match the capacity range between the two points (ni, nf) of the reference negative electrode profile (Rn) with the capacity range of the measured full-cell profile (M). In this instance, any one of the two points (ni, nf) may be fixed. Accordingly, the capacity range between the two points (ni, nf) of the adjusted reference negative electrode profile (Rn') may match the capacity range of the measured full-cell profile (M).

In FIG. 8, the adjusted reference positive electrode profile (Rp") is the result of contracting the adjusted reference positive electrode profile (Rp') shown in FIG. 7, and the adjusted reference negative electrode profile (Rn') is the result of expanding the reference negative electrode profile (Rn) shown in FIG. 7.

The positive electrode participation end point (pf") on the adjusted reference positive electrode profile (Rp") corresponds to the positive electrode participation end point (pf) on the adjusted reference positive electrode profile (Rp'). The negative electrode participation end point (nf) on the adjusted reference negative electrode profile (Rn') corresponds to the negative electrode participation end point (nf) on the reference negative electrode profile (Rn).

The capacity range between the positive electrode participation start point (pi') and the positive electrode participation end point (pf") of the adjusted reference positive electrode profile (Rp") matches the capacity range of the measured full-cell profile (M). Likewise, the capacity range between the negative electrode participation start point (ni) and the negative electrode participation end point (nf) of the adjusted reference negative electrode profile (Rn') matches the capacity range of the measured full-cell profile (M).

In addition, the capacity range between the two points (pi', pf') of the adjusted reference positive electrode profile (Rp") matches the capacity range between the two points (ni, nf) of the adjusted reference negative electrode profile (Rn'). The profile determination unit 110 may subtract the profile between the two points (pi', pf") of the adjusted reference positive electrode profile (Rp") from the profile between the two points (ni, nf) of the adjusted reference negative electrode profile (Rn') to generate a comparative full-cell profile (S).

The profile determination unit 110 may calculate an error (a profile error) between the comparative full-cell profile (S) and the measured full-cell profile (M).

The profile determination unit 110 may map at least two of the adjusted reference positive electrode profile (Rp"), the adjusted reference negative electrode profile (Rn'), the positive electrode participation start point (pi'), the positive electrode participation end point (pf"), the negative electrode participation start point (ni), the negative electrode participation end point (nf), a first scale factor, a second scale factor, the comparative full-cell profile (S), and the profile error, and record in the storage unit 150. The first scale factor may represent a ratio of a capacity difference between two points (pi', pf') to a capacity difference between two points (pi0, pf0). The second scale factor may represent a ratio of a capacity difference between two points (ni, nf) to a capacity difference between two points (ni0, nf0).

Here, the profile determination unit 110 may calculate the positive electrode change ratio (ps) of the adjusted reference positive electrode profile (Rp") with respect to the reference positive electrode profile (Rp). Additionally, the profile determination unit 110 may calculate the negative electrode change ratio (ns) of the adjusted reference negative electrode profile (Rn') with respect to the reference negative electrode profile (Rn). For example, the profile determination unit 110 may determine the first scale factor as the positive electrode change ratio (ps) and the second scale factor as the negative electrode change ratio (ns).

Meanwhile, as described above, when the positive electrode voltage range of the reference positive electrode profile (Rp) is divided into the plurality of voltage subranges, the boundary point of two adjacent voltage subranges among the plurality of voltage subranges may be set as the positive electrode participation start point (pi).

For example, when the positive electrode voltage range of the reference positive electrode profile (Rp) is divided into 100 voltage subranges, the number of boundary points that may be set as the positive electrode participation start point (pi) may be 100. In addition, when the voltage range that is equal to or more than the second set voltage in the reference positive electrode profile (Rp) is divided into 40 voltage subranges, the number of boundary points that may be set as the positive electrode participation end point (pf) may be 40. In this case, a maximum of 4000 different comparative full-cell profiles may be generated.

Those skilled in the art will easily understand that as the size of the voltage subrange decreases, the maximum possible number of comparative full-cell profiles increases, and on the contrary, as the size of the voltage subrange increases, the maximum possible number of comparative full-cell profiles decreases.

The profile determination unit 110 may identify the minimum profile error among the profile errors of the plurality of comparative full-cell profiles generated as described above, and obtain information mapped to the minimum profile error (for example, at least one of the positive electrode participation start point, the positive electrode participation end point, the negative electrode participation start point, the negative electrode participation end point, the first scale factor, and the second scale factor) from the storage unit 150.

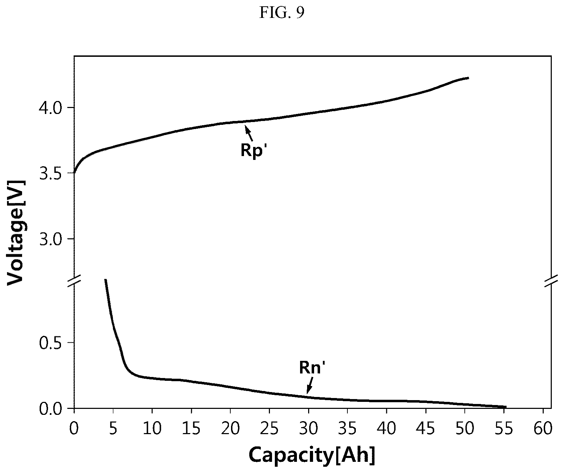

FIGS. 9 to 11 are diagrams referenced in describing another example of the procedure for generating the comparative full-cell profile used for comparison with the measured full-cell profile according to an embodiment of the present disclosure. For reference, the embodiment according to FIGS. 9 to 11 are independent from the embodiment according to FIGS. 6 to 8. Therefore, it should be understood that the terms or symbols in common when describing the embodiment according to FIGS. 6 to 8 and the embodiment according to FIGS. 9 to 11 are limited to each embodiment.

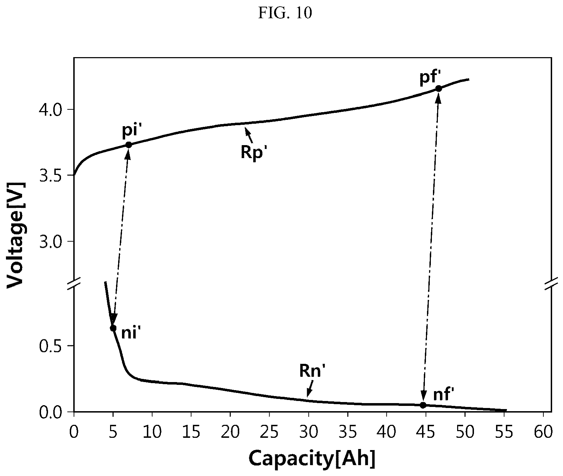

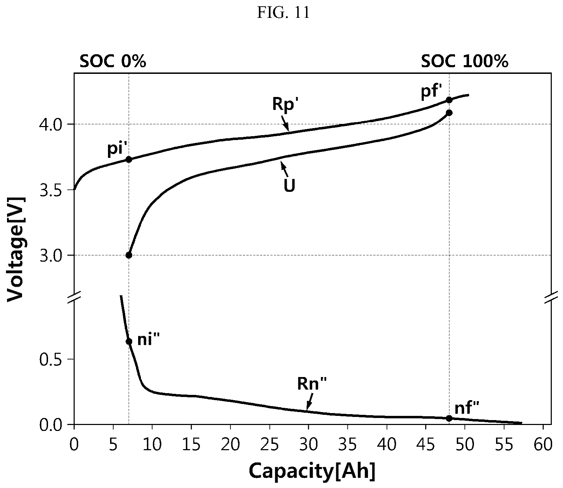

The procedure for generating the comparative full-cell profile as described below with reference to FIGS. 9 to 11 is performed in an order of a fourth routine (see FIG. 9) of performing capacity scaling, a fifth routine (see FIG. 10) of setting four points (the positive electrode participation start point, the positive electrode participation end point, the negative electrode participation start point, the negative electrode participation end point), and a sixth routine (see FIG. 11) of performing profile shift. That is, the procedure for generating the comparative full-cell profile according to another embodiment of the present disclosure includes the fourth to sixth routines.

Referring to FIG. 9, the reference positive electrode profile (Rp) and the reference negative electrode profile (Rn) are the same as those shown in FIG. 4.

The profile determination unit 110 applies the first scale factor and the second scale factor selected from a scaling value range to the reference positive electrode profile (Rp) and the reference negative electrode profile (Rn), respectively, to generate the adjusted reference positive electrode profile (Rp') and the adjusted reference negative electrode profile (Rn').

The scaling value range may be preset or may vary depending on a ratio of the size of the capacity range of the measured full-cell profile (M) to the size of the capacity range of the reference full-cell profile (R). For example, when the first scale factor and the second scale factor may be selected from the scaling value range (for example, 90% to 99%) of values (i.e., 90%, 90.1%, 90.2%, ... 98.9%, 99%) at an interval of 0.1%, 91 values may be selected as each of the first scale factor and the second scale factor. In this case, a maximum of 8,281 adjusted profile pairs may be generated according to $91 \times 91 = 8,281$ adjustment levels (a combination of the first scale factor and the second scale factor). The adjusted profile pair refers to a combination of the adjusted positive electrode profile and the adjusted negative electrode profile.

The adjusted reference positive electrode profile (Rp') and the adjusted reference negative electrode profile (Rn') shown in FIG. 9 are the result of applying the first scale factor and the second scale factor of less than 100% to the reference positive electrode profile (Rp) and the reference negative electrode profile (Rn), respectively.

Because the first scale factor and the second scale factor are less than 100%, the adjusted reference positive electrode profile (Rp') is the result of contracting the reference positive electrode profile (Rp) along the horizontal axis, and the adjusted reference negative electrode profile (Rn') is also the result of contracting the reference negative electrode profile (Rn) along the horizontal axis. To help understanding, while the start point of each of the positive electrode profile (Rp) and the reference negative electrode profile (Rn) stays fixed, the remaining part is contracted to the left along the horizontal axis.

Referring to FIG. 10, the profile determination unit 110 determines the positive electrode participation start point (pi'), the positive electrode participation end point (pf), the negative electrode participation start point (ni'), and the negative electrode participation end point (nf) on the adjusted reference positive electrode profile (Rp') and the adjusted reference negative electrode profile (Rn').

Any one of the positive electrode participation start point (pi') and the negative electrode participation start point (ni') may rely on the other. Furthermore, any one of the positive electrode participation end point (pf) and the negative electrode participation end point (nf) may rely on the other. Additionally, any one of the positive electrode participation start point (pi') and the positive electrode participation end point (pf) may be set based on the other.

That is, when any one of the positive electrode participation start point (pi'), the positive electrode participation end point (pf), the negative electrode participation start point (ni') and the negative electrode participation end point (nf) is set, the remaining three points may be automatically set by the first set voltage, the second set voltage and/or the size of the capacity range of the measured full-cell profile (M) (for example, the charge capacity at SOC 0 to 100%).

As an example, the profile determination unit 110 may divide the positive electrode voltage range from the start point to the end point (or the second set voltage) of the adjusted reference positive electrode profile (Rp') into a plurality of voltage subranges, and set the boundary point of two adjacent voltage subranges among the plurality of voltage subranges as the positive electrode participation start point (pi'). Subsequently, the profile determination unit 110 may set a point on the adjusted reference negative electrode profile (Rn) that is smaller than the positive electrode participation start point (pi') by the first set voltage (for example, 3 V) as the negative electrode participation start point (ni').

As another example, the profile determination unit 110 may divide the negative electrode voltage range from the start point to the end point of the adjusted reference negative electrode profile (Rn') into a plurality of voltage subranges of a predetermined size, and set the boundary point of two adjacent voltage subranges among the plurality of voltage subranges as the negative electrode participation start point (ni'). Subsequently, the profile determination unit 110 may search for a point that is larger than the negative electrode participation start point (ni') by the first set voltage from the adjusted reference positive electrode profile (Rp'), and set the found point as the positive electrode participation start point (pi').

As still another example, the profile determination unit 110 may divide the voltage range from the second set voltage to the end point of the adjusted reference positive electrode profile (Rp') into a plurality of voltage subranges of a predetermined size, and set the boundary point of two adjacent voltage subranges among the plurality of voltage subranges as the positive electrode participation end point (pf'). Subsequently, the profile determination unit 110 may search for a point that is smaller than the positive electrode participation end point (pf) by the second set voltage (for example, 4 V) from the adjusted reference negative electrode profile (Rn'), and set the found point as the negative electrode participation end point (nf).

As yet another example, the profile determination unit 110 may divide the negative electrode voltage range from the start point to the end point of the adjusted reference negative electrode profile (Rn') into a plurality of voltage subranges of a predetermined size, and set the boundary point of two adjacent voltage subranges among the plurality of voltage subranges as the negative electrode participation end point (nf). Subsequently, the profile determination unit 110 may search for a point that is larger than the negative electrode participation end point (nf) by the second set voltage from the adjusted reference positive electrode profile (Rp'), and set the found point as the positive electrode participation end point (pf).

When any one of the positive electrode participation start point (pi'), the positive electrode participation end point (pf), the negative electrode participation start point (ni'), and the negative electrode participation end point (nf) is determined, the profile determination unit 110 may additionally determine the remaining three points based on the determined point.

As an example, when the positive electrode participation start point (pi') is first determined, the profile determination unit 110 may set, as the positive electrode participation end point (pf), a point on the adjusted reference positive electrode profile (Rp') having a larger capacity value than the capacity value of the positive electrode participation start point (pi') by the size of the capacity range of the measured full-cell profile (M). In addition, the profile determination unit 110 may search for a point of lower voltage than the voltage of the positive electrode participation start point (pi') by the first set voltage from the adjusted reference negative electrode profile (Rn'), and set the found point as the negative electrode participation start point (ni'). In addition, the profile determination unit 110 may set, as the negative electrode participation end point (nf), a point on the adjusted reference negative electrode profile (Rn') having a larger capacity value than the capacity value of the negative electrode participation start point (ni') by the size of the capacity range of the measured full-cell profile (M).

As another example, when the positive electrode participation end point (pf) is first determined, the profile determination unit 110 may set, as the positive electrode participation start point (pi'), a point on the adjusted reference positive electrode profile (Rp') having a smaller capacity value than the capacity value of the positive electrode participation end point (pf) by the size of the capacity range of the measured full-cell profile (M). In addition, the profile determination unit 110 may search for a point of lower voltage than the voltage of the positive electrode participation end point (pf) by the second set voltage from the adjusted reference negative electrode profile (Rn'), and set the found point as the negative electrode participation end point (nf). In addition, the profile determination unit 110 may set, as the negative electrode participation start point (ni'), a point on the adjusted reference negative electrode profile (Rn') having a smaller capacity value than the capacity value of the negative electrode participation end point (nf') by the size of the capacity range of the measured full-cell profile (M).

As still another example, when the negative electrode participation start point (ni') is determined, the profile determination unit 110 may set, as the negative electrode participation end point (nf'), a point on the adjusted reference negative electrode profile (Rn') having a larger capacity value than the capacity value of the negative electrode participation start point (ni') by the size of the capacity range of the measured full-cell profile (M). In addition, the profile determination unit 110 may search for a point of lower voltage than the voltage of the negative electrode participation start point (ni') by the first set voltage from the adjusted reference positive electrode profile (Rp') and set the found point as the positive electrode participation start point (pi'). In addition, the profile determination unit 110 may set, as the positive electrode participation end point (pf), a point on the adjusted reference positive electrode profile (Rp') having a larger capacity value than the capacity value of the positive electrode participation start point (pi') by the size of the capacity range of the measured full-cell profile (M).

As yet another example, when the negative electrode participation end point (nf) is determined, the profile determination unit 110 may set, as the negative electrode participation start point (ni'), a point on the adjusted reference negative electrode profile (Rn') having a smaller capacity value than the capacity value of the negative electrode participation end point (nf) by the size of the capacity range of the measured full-cell profile (M). In addition, the profile determination unit 110 may search for a point of lower voltage than the voltage of the negative electrode participation end point (nf) by the second set voltage from the adjusted reference positive electrode profile (Rp') and set the found point as the positive electrode participation end point (pf). In addition, the profile determination unit 110 may set, as the positive electrode participation start point (pi'), a point on the adjusted reference positive electrode profile (Rp') having a smaller capacity value than the capacity value of the positive electrode participation end point (pf') by the size of the capacity range of the measured full-cell profile (M).

When the determination of the positive electrode participation start point (pi'), the positive electrode participation end point (pf), the negative electrode participation start point (ni'), and the negative electrode participation end point (nf) is completed based on the pair of the first scale factor and the second scale factor, the profile determination unit 110 may shift at least one of the adjusted reference positive electrode profile (Rp') and the adjusted reference negative electrode profile (Rn') to the left or right along the horizontal axis to match the capacity values of the positive electrode participation start point (pi') and the negative electrode participation start point (ni') or match the capacity values of the positive electrode participation end point (pf) and the negative electrode participation end point (nf).

The adjusted reference negative electrode profile (Rn") shown in FIG. 11 is the result of shifting only the adjusted reference negative electrode profile (Rn') shown in FIG. 10 to the right. Accordingly, the capacity values of the positive electrode participation start point (pi') and the negative electrode participation start point (ni") match each other. In relation to this, because the capacity difference between the positive electrode participation start point (pi') and the positive electrode participation end point (pf) is equal to the capacity difference between the negative electrode participation start point (ni') and the negative electrode participation end point (nf), when the capacity values of the positive electrode participation start point (pi') and the negative electrode participation start point (ni") match each other, the capacity values of the positive electrode participation end point (pf) and the negative electrode participation end point (nf') also match each other.

Referring to FIG. 11, the profile determination unit 110 may subtract the partial profile between the two points (pi', pf') of the adjusted reference positive electrode profile (Rp') from the partial profile between the two points (ni", nf') of the adjusted reference negative electrode profile (Rn") to generate a comparative full-cell profile (U).

The profile determination unit 110 may calculate an error (a profile error) between the comparative full-cell profile (U) and the measured full-cell profile (M).

The profile determination unit 110 may map at least two of the adjusted reference positive electrode profile (Rp'), the adjusted reference negative electrode profile (Rn"), the positive electrode participation start point (pi'), the positive electrode participation end point (pf), the negative electrode participation start point (ni"), the negative electrode participation end point (nf'), the first scale factor, the second scale factor, the comparative full-cell profile (U), and the profile error, and record in the storage unit 150.

Here, the profile determination unit 110 may calculate the positive electrode change ratio (ps) of the adjusted reference positive electrode profile (Rp') with respect to the reference positive electrode profile (Rp). Additionally, the profile determination unit 110 may calculate the negative electrode change ratio (ns) of the adjusted reference negative electrode profile (Rn") with respect to the reference negative electrode profile (Rn). For example, the profile determination unit 110 may determine the first scale factor as the positive electrode change ratio (ps) and the second scale factor as the negative electrode change ratio (ns).

As described above, the profile determination unit 110 may generate the comparative full-cell profile corresponding to each pair of the first scale factor and the second scale factor selected from the scaling value range. In the presence of the multiple pairs of the first scale factor and the second scale factor, obviously a plurality of comparative full-cell profiles will be generated. The profile determination unit 110 may identify the minimum profile error among the profile errors of the plurality of comparative full-cell profiles, and obtain information mapped to the minimum profile error from the storage unit 150.

The battery diagnosis apparatus 100 according to the present disclosure may be connected to a display device (not shown) to output information of the battery diagnosed as abnormal. The display device may display the information of the battery diagnosed as abnormal.

The battery diagnosis apparatus 100 according to the present disclosure may be connected to an alarm device (not shown). The alarm device may operate upon the output of the information of the battery diagnosed as abnormal.

The battery diagnosis apparatus 100 according to the present disclosure may be applied to a Battery Management System (BMS). That is, the BMS according to the present disclosure may include the battery diagnosis apparatus 100. In this configuration, at least some of the components of the battery diagnosis apparatus 100 may be implemented by supplementing or adding the functions of the components generally included in the BMS. For example, the profile determination unit 110, the loading amount calculation unit 120, the condition diagnosis unit 130, the resistance calculation unit 140, and the storage unit 150 of the battery diagnosis apparatus 100 may be implemented as the components of the BMS.

In addition, the battery diagnosis apparatus 100 according to the present disclosure may be equipped in a battery pack 1. That is, the battery pack 1 according to the present disclosure may include the battery diagnosis apparatus 100 and at least one battery cell. In addition, the battery pack 1 may further include electrical components (relay, fuse) and a case.

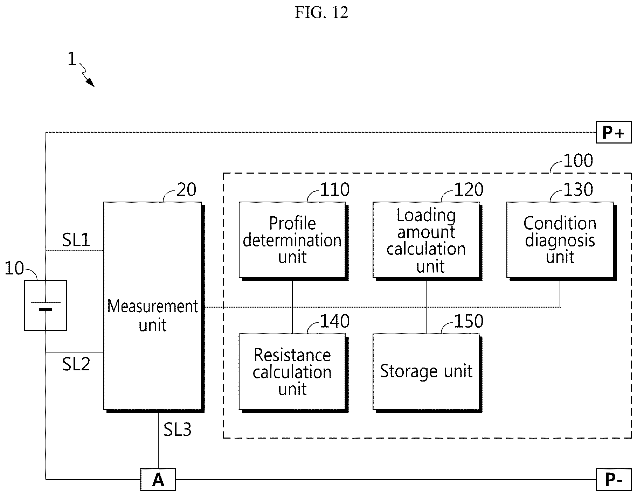

FIG. 12 is a diagram illustrating the exemplary configuration of the battery pack 1 including the battery diagnosis apparatus 100 according to an embodiment of the present disclosure.

A positive terminal of the battery 10 may be connected to a positive terminal (P+) of the battery pack 1, and a negative terminal of the battery 10 may be connected to a negative terminal (P-) of the battery pack 1.

The measurement unit 20 may be connected to a first sensing line SL1, a second sensing line SL2, and a third sensing line SL3. Specifically, the measurement unit 20 may be connected to the positive terminal of the battery 10 through the first sensing line SL1, and to the negative terminal of the battery 10 through the second sensing line SL2. The measurement unit 20 may measure the voltage of the battery 10 based on the voltage measured at each of the first sensing line SL1 and the second sensing line SL2.

Additionally, the measurement unit 20 may be connected to a current measurement unit A through the third sensing line SL3. For example, the current measurement unit A may be an ammeter or a shunt resistor for measuring the charging current and the discharging current of the battery 10. The measurement unit 20 may measure the charging current of the battery 10 through the third sensing line SL3 and calculate the charging amount. In addition, the measurement unit 20 may measure the discharging current of the battery 10 through the third sensing line SL3 and calculate the discharging amount.

A load may be, at one end, connected to the positive terminal (P+) of the battery pack 1 and at the other end, connected to the negative terminal (P-) of the battery pack 1. Accordingly, the positive terminal of the battery 10, the positive terminal (P+) of the battery pack 1, the load, the negative terminal (P-) of the battery pack 1, and the negative terminal of the battery 10 may be electrically connected.

For example, the load may be a charger/discharger, or a motor of an electric vehicle that is supplied with power from the battery 10.

The battery diagnosis apparatus 100 according to an embodiment of the present disclosure may be included in a battery manufacturing system (not shown).

Here, the battery manufacturing system may be a system applied to a battery manufacturing process. For example, the battery may include an electrode assembly, an outer packaging, and an electrolyte solution. The outer packaging provides a space for accommodating the electrode assembly, and when the electrolyte solution is injected into the space, at least part of the electrode assembly may be filled with the electrolyte solution. When the outer packaging is sealed, the manufacture of the battery may be completed. Subsequently, the battery may go through an activation process and a degassing process.

Additionally, the condition of the manufactured battery may be diagnosed by the battery diagnosis apparatus 100. Preferably, the condition of the target battery may be diagnosed based on the resistance distribution and positive electrode loading distribution of a plurality of reference batteries manufactured through the same process.

The battery manufacturing system according to an embodiment of the present disclosure may diagnose whether the manufactured battery is in normal or abnormal condition by diagnosing whether at least one of the active material, the binder, and the conductive material is included in the positive electrode of the manufactured battery in a larger amount.

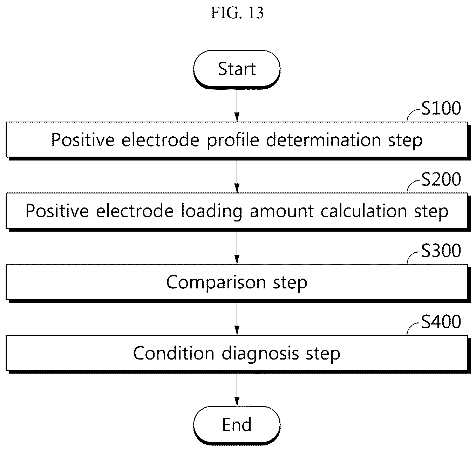

FIG. 13 is a flowchart exemplarily showing a battery diagnosis method according to an embodiment of the present disclosure.

Preferably, each step of the battery diagnosis method may be performed by the battery diagnosis apparatus 100. Hereinafter, for convenience of description, any description shared with the foregoing description is omitted or will be briefly described.

Referring to FIG. 13, the battery diagnosis method may include a positive electrode profile determination step S100, a positive electrode loading amount calculation step S200, a comparison step S300, and a condition diagnosis step S400.

The positive electrode profile determination step S 100 is a step of determining, by the profile determination unit 110, the positive electrode profile of the battery by adjusting the reference positive electrode profile and the reference negative electrode profile to the measured full-cell profile indicating the correspondence relationship between capacity and voltage of the battery.

For example, the profile determination unit 110 may shift or capacity-scale the reference positive electrode profile and the reference negative electrode profile to fit into the measured full-cell profile.

The positive electrode loading amount calculation step S200 is a step of calculating, by the loading amount calculation unit 120, the positive electrode loading amount of the battery based on the positive electrode profile of the battery.

For example, the loading amount calculation unit 120 may calculate the positive electrode loading amount, taking into account the positive electrode change ratio, the preset reference positive electrode capacity, and the preset reference area.

The comparison step S300 is a step of comparing, by the condition diagnosis unit 130, the resistance of the battery with the preset resistance range and the positive electrode loading amount of the battery with the preset loading amount range.

For example, when the positive electrode loading amount of the battery is equal to or less than the upper limit of the loading amount range and equal to or more than the lower limit, the condition diagnosis unit 130 may determine that the positive electrode loading amount of the battery lies within the loading amount range.

On the contrary, when the positive electrode loading amount of the battery is more than the upper limit of the loading amount range or less than the lower limit, the condition diagnosis unit 130 may determine that the positive electrode loading amount of the battery does not lie within the loading amount range.

The condition diagnosis step S400 is a step for diagnosing, by the condition diagnosis unit 130, the condition of the battery based on the resistance comparison result and the positive electrode loading amount comparison result.

For example, the condition diagnosis unit 130 may diagnose the condition of the battery as normal when the resistance lies within the resistance range and the positive electrode loading amount lies within the loading amount range.

On the contrary, the condition diagnosis unit 130 may diagnose the condition of the battery as abnormal when the resistance does not lie within the resistance range or the positive electrode loading amount does not lie within the loading amount range.

The embodiments of the present disclosure as described herein are not embodied only through the apparatus and method, and may be implemented through programs that perform the functions corresponding to the exemplary configurations of the present disclosure or recording media having the programs recorded thereon, and such implementation may be easily achieved by those skilled in the art from the disclosure of the embodiments previously described.

Although the present disclosure has been hereinabove described with regard to a limited number of embodiments and drawings, the present disclosure is not limited thereto and it is obvious to those skilled in the art that various modifications and changes may be made thereto within the technical aspect of the present disclosure and the scope of the appended claims and their equivalents.

Additionally, as many substitutions, modifications and changes may be made to the present disclosure as described above by those skilled in the art without departing from the technical aspect of the present disclosure, the present disclosure is not limited by the above-described embodiments and the accompanying drawings, and some or all of the embodiments may be selectively combined to allow various modifications.

[List of Reference Numerals]

100: Battery diagnosis apparatus
110: Profile determination unit
120: Loading amount calculation unit
130: Condition diagnosis unit
140: Resistance calculation unit
150: Storage unit

**Claims**

1. A battery diagnosis apparatus comprising:

   a profile determination unit configured to determine a positive electrode profile of a battery by adjusting a reference positive electrode profile and a reference negative electrode profile to fit into a measured full-cell profile indicating a correspondence relationship between capacity and voltage of the battery;
   a loading amount calculation unit configured to calculate a positive electrode loading amount of the battery based on the positive electrode profile of the battery; and
   a condition diagnosis unit configured to compare a resistance of the battery with a preset resistance range and the positive electrode loading amount of the battery with a preset loading amount range, and diagnose a condition of the battery based on the resistance comparison result and the positive electrode loading amount comparison result.

2. The battery diagnosis apparatus according to claim 1,
   wherein the condition diagnosis unit is configured to:

   diagnose the condition of the battery as normal when the resistance lies within the resistance range and the positive electrode loading amount lies within the loading amount range, and
   diagnose the condition of the battery as abnormal when the resistance is outside of the resistance range or the positive electrode loading amount is outside of the loading amount range.

3. The battery diagnosis apparatus according to claim 2,
   wherein the abnormal condition is a condition in which at least one of an active material, a binder, or a conductive material is included in a positive electrode of the battery in a larger amount.

4. The battery diagnosis apparatus according to claim 1,
   wherein the loading amount calculation unit is configured to:
   calculate the positive electrode loading amount, taking into account a positive electrode change ratio of the positive electrode profile of the battery with respect to the reference positive electrode profile.

5. The battery diagnosis apparatus according to claim 4,
   wherein the loading amount calculation unit is configured to:
   calculate the positive electrode loading amount, taking into account the positive electrode change ratio, a preset reference positive electrode capacity, and a preset reference area.

6. The battery diagnosis apparatus according to claim 5,
   wherein the loading amount calculation unit is configured to:
   calculate the positive electrode loading amount indicating a positive electrode capacity per unit area by multiplying the reference positive electrode capacity by the positive electrode change ratio and dividing a product by the reference area.

7. The battery diagnosis apparatus according to claim 1,

   wherein the resistance range is a range that is set based on a resistance distribution of a plurality of reference batteries, and
   wherein the loading amount range is a range that is set based on a positive electrode loading amount distribution of the plurality of reference batteries.

8. The battery diagnosis apparatus according to claim 1, further comprising:
   a resistance calculation unit configured to calculate the resistance of the battery based on the measured full-cell profile.

9. A battery manufacturing system comprising the battery diagnosis apparatus according to claim 1.

10. A battery pack comprising the battery diagnosis apparatus according to claim 1.

11. A battery diagnosis method comprising:

    a positive electrode profile determination step of determining a positive electrode profile of a battery by adjusting a reference positive electrode profile and a reference negative electrode profile to fit into a measured full-cell profile indicating a correspondence relationship between capacity and voltage of the battery;
    a positive electrode loading amount calculation step of calculating a positive electrode loading amount of the battery based on the positive electrode profile of the battery;
    a comparison step of comparing a resistance of the battery with a preset resistance range and the positive electrode loading amount of the battery with a preset loading amount range; and
    a condition diagnosis step of diagnosing a condition of the battery based on the resistance comparison result and the positive electrode loading amount comparison result of the comparison step.

FIG. 1

Battery diagnosis apparatus — 100

- Profile determination unit — 110
- Loading amount calculation unit — 120
- Condition diagnosis unit — 130
- Resistance calculation unit — 140
- Storage unit — 150

FIG. 2

|  | More than upper limit | Less than lower limit | Within range |
|---|---|---|---|
| Resistance | Conductive material in smaller amount | Conductive material in larger amount | Conductive material in optimal amount |
| Positive electrode loading amount | Active material in larger amount | Active material in smaller amount | Active material in optimal amount |

FIG. 3

| Resistance / Positive electrode loading amount | More than upper limit | Less than lower limit | Within range |
|---|---|---|---|
| More than upper limit | | Binder in smaller amount | Binder in smaller amount |
| Less than lower limit | Binder in larger amount | | Binder in larger amount |
| Within range | Binder in larger amount | Binder in smaller amount | Binder in optimal amount |

FIG. 4

FIG. 5

FIG. 6

FIG. 7

FIG. 8

FIG. 9

FIG. 10

FIG. 11

FIG. 12

FIG. 13

## INTERNATIONAL SEARCH REPORT

| International application No. |
|---|
| **PCT/KR2024/013974** |

| A. | CLASSIFICATION OF SUBJECT MATTER |
|---|---|

**G01R 31/382**(2019.01)i; **G01R 31/385**(2019.01)i; **G01R 31/396**(2019.01)i; **G01R 31/389**(2019.01)i; **G01R 27/08**(2006.01)i; **H01M 4/13**(2010.01)i; **H01M 10/04**(2006.01)i; **H01M 4/02**(2006.01)i

According to International Patent Classification (IPC) or to both national classification and IPC

| B. | FIELDS SEARCHED |
|---|---|

Minimum documentation searched (classification system followed by classification symbols)

G01R 31/382(2019.01); G01R 31/36(2006.01); G01R 31/367(2019.01); H01M 10/0525(2010.01); H01M 10/42(2006.01); H01M 10/48(2006.01); H01M 4/13(2010.01)

Documentation searched other than minimum documentation to the extent that such documents are included in the fields searched

Korean utility models and applications for utility models: IPC as above
Japanese utility models and applications for utility models: IPC as above

Electronic data base consulted during the international search (name of data base and, where practicable, search terms used)

eKOMPASS (KIPO internal) & keywords: 배터리(battery), 용량(capacity), 전압(voltage), 프로파일(profile), 양극 로딩값 (anode loading value)

| C. | DOCUMENTS CONSIDERED TO BE RELEVANT |
|---|---|

| Category* | Citation of document, with indication, where appropriate, of the relevant passages | Relevant to claim No. |
|---|---|---|
| Y | KR 10-2022-0093840 A (LG ENERGY SOLUTION, LTD.) 05 July 2022 (2022-07-05)<br>See paragraphs [0006] and [0077]-[0144] and claims 1-8. | 1-11 |
| Y | KR 10-2018-0134309 A (LG CHEM, LTD.) 18 December 2018 (2018-12-18)<br>See paragraphs [0017]-[0036] and figure 1. | 1-11 |
| A | KR 10-2022-0021730 A (LG ENERGY SOLUTION, LTD.) 22 February 2022 (2022-02-22)<br>See paragraphs [0034]-[0048] and figures 1-3. | 1-11 |
| A | KR 10-2019-0044450 A (LG CHEM, LTD.) 30 April 2019 (2019-04-30)<br>See claims 1-10 and figure 1. | 1-11 |
| A | CN 105242212 A (HARBIN INSTITUTE OF TECHNOLOGY) 13 January 2016 (2016-01-13)<br>See paragraphs [0027]-[0055]. | 1-11 |

☐ Further documents are listed in the continuation of Box C.   ☑ See patent family annex.

| | Special categories of cited documents: | | |
|---|---|---|---|
| "A" | document defining the general state of the art which is not considered to be of particular relevance | "T" | later document published after the international filing date or priority date and not in conflict with the application but cited to understand the principle or theory underlying the invention |
| "D" | document cited by the applicant in the international application | "X" | document of particular relevance; the claimed invention cannot be considered novel or cannot be considered to involve an inventive step when the document is taken alone |
| "E" | earlier application or patent but published on or after the international filing date | | |
| "L" | document which may throw doubts on priority claim(s) or which is cited to establish the publication date of another citation or other special reason (as specified) | "Y" | document of particular relevance; the claimed invention cannot be considered to involve an inventive step when the document is combined with one or more other such documents, such combination being obvious to a person skilled in the art |
| "O" | document referring to an oral disclosure, use, exhibition or other means | "&" | document member of the same patent family |
| "P" | document published prior to the international filing date but later than the priority date claimed | | |

| Date of the actual completion of the international search | Date of mailing of the international search report |
|---|---|
| **27 December 2024** | **27 December 2024** |

| Name and mailing address of the ISA/KR | Authorized officer |
|---|---|
| **Korean Intellectual Property Office**<br>**Government Complex-Daejeon Building 4, 189 Cheongsa-ro, Seo-gu, Daejeon 35208** | |
| Facsimile No. **+82-42-481-8578** | Telephone No. |

Form PCT/ISA/210 (second sheet) (July 2022)

**INTERNATIONAL SEARCH REPORT**
Information on patent family members

International application No.

**PCT/KR2024/013974**

| Patent document cited in search report | | | Publication date (day/month/year) | Patent family member(s) | | | Publication date (day/month/year) |
|---|---|---|---|---|---|---|---|
| KR | 10-2022-0093840 | A | 05 July 2022 | CN | 115380221 | A | 22 November 2022 |
| | | | | EP | 4119962 | A1 | 18 January 2023 |
| | | | | EP | 4119962 | A4 | 29 November 2023 |
| | | | | JP | 2023-515838 | A | 14 April 2023 |
| | | | | JP | 7395809 | B2 | 12 December 2023 |
| | | | | US | 12066496 | B2 | 20 August 2024 |
| | | | | US | 2023-0236262 | A1 | 27 July 2023 |
| | | | | US | 2024-0377472 | A1 | 14 November 2024 |
| | | | | WO | 2022-145776 | A1 | 07 July 2022 |
| KR | 10-2018-0134309 | A | 18 December 2018 | CN | 110088945 | A | 02 August 2019 |
| | | | | EP | 3534436 | A1 | 04 September 2019 |
| | | | | EP | 3534436 | A4 | 06 November 2019 |
| | | | | EP | 3534436 | B1 | 09 December 2020 |
| | | | | PL | 3534436 | T3 | 19 April 2021 |
| | | | | US | 11322736 | B2 | 03 May 2022 |
| | | | | US | 2019-0280286 | A1 | 12 September 2019 |
| | | | | WO | 2018-226070 | A1 | 13 December 2018 |
| KR | 10-2022-0021730 | A | 22 February 2022 | CN | 115413382 | A | 29 November 2022 |
| | | | | EP | 4131571 | A1 | 08 February 2023 |
| | | | | EP | 4131571 | A4 | 27 September 2023 |
| | | | | JP | 2023-517738 | A | 26 April 2023 |
| | | | | JP | 7372007 | B2 | 31 October 2023 |
| | | | | KR | 10-2596153 | B1 | 30 October 2023 |
| | | | | US | 11990590 | B2 | 21 May 2024 |
| | | | | US | 2023-0207910 | A1 | 29 June 2023 |
| | | | | US | 2024-0274902 | A1 | 15 August 2024 |
| | | | | WO | 2022-035032 | A1 | 17 February 2022 |
| KR | 10-2019-0044450 | A | 30 April 2019 | CN | 111247672 | A | 05 June 2020 |
| | | | | CN | 111247672 | B | 05 May 2023 |
| | | | | EP | 3683867 | A1 | 22 July 2020 |
| | | | | EP | 3683867 | A4 | 11 November 2020 |
| | | | | EP | 3683867 | B1 | 17 April 2024 |
| | | | | HU | E066364 | T2 | 28 July 2024 |
| | | | | PL | 3683867 | T3 | 01 July 2024 |
| | | | | US | 11545660 | B2 | 03 January 2023 |
| | | | | US | 2020-0251728 | A1 | 06 August 2020 |
| | | | | WO | 2019-078691 | A1 | 25 April 2019 |
| CN | 105242212 | A | 13 January 2016 | CN | 105242212 | B | 30 January 2018 |

Form PCT/ISA/210 (patent family annex) (July 2022)

**EP 4 692 821 A1**

**REFERENCES CITED IN THE DESCRIPTION**

**Patent documents cited in the description**

- KR 1020230126639